# DEMANDE DE BREVET EUROPEEN

(11) **EP 1 107 259 A1**
(43) Date de publication de la demande: **13.06.2001**
(21) Numéro de dépôt: 00403338.7
(22) Date de dépôt: 29.11.2000
(51) Int. Cl.: G11C 16/24, G11C 16/28, G11C 7/12

(54) **Dispositif de lecture pour mémoire en circuit intégré**

(30) Priorité: 30.11.1999 FR 9915114
(71) Demandeur: STMicroelectronics S.A., 94250 Gentilly (FR); STMicroelectronics S.r.l., 20041 Agrate Brianza (Milano) (IT)
(72) Inventeur: Fournel, Richard, 94230 Cachan (FR); Varisco, Laura, 94230 Cachan (FR)
(74) Mandataire: Ballot, Paul

(57) **Abrégé**

Dans un dispositif de lecture d'une mémoire, on prévoit des moyens de précharge PRECH_{MTX,} PRECH_{REF} des entrées de l'amplificateur différentiel 2 à une même tension de précharge Vbias2, de niveau intermédiaire entre le niveau de précharge Vbiasl des lignes de bit et le niveau de la tension d'alimentation logique Vdd, permettant, dans une phase suivante d'évaluation, l'établissement très rapide de la sortie de l'amplificateur dans un état correspondant à celui de la cellule lue.

Des moyens internes de détection 50 détectent la fin de la précharge, permettant de stopper les moyens de précharge et d'activer le générateur de courant de lecture pour la phase d'évaluation.

## Description

La présente invention concerne un dispositif de lecture pour une mémoire en circuit intégré.

Elle s'applique notamment, mais pas exclusivement, aux mémoires non volatiles électriquement programmables de type EPROM ou OTP.

Un objet de l'invention est d'améliorer le temps d'accès en lecture des mémoires, c'est à dire le temps au bout duquel la donnée reflétant l'état mémorisé dans une ou des cellules mémoire est disponible en sortie.

On rappelle que les cellules d'une mémoire sont habituellement organisées matriciellement en lignes de bit et lignes de mot. Les lignes de bit sont les conducteurs par lesquels l'état mémorisé dans une cellule est lu. Ainsi, quand une cellule mémoire est adressée en lecture, la ligne de mot correspondante est sélectionnée et la ligne de bit correspondante est connectée à un dispositif de lecture.

En général, on ne lit pas une seule cellule mémoire, mais plusieurs, permettant la lecture d'un mot mémoire. De manière générale, toutes ces cellules formant un mot mémoire sont rattachées à la même ligne de mot, et à chacune correspond une ligne de bit respective.

En lecture, chacune de ces lignes de bit est connectée à un dispositif de lecture correspondant.

Tous ces dispositifs de lecture sont identiques.

Comme les lignes de bit comportent un grand nombre de cellules, elles sont capacitives (du fait de la somme des capacités individuelles dues aux composants eux-mêmes ; cellules, transistors de sélection, et dues à la topologie des lignes de bit) et résistives (du fait de l'ensemble des matériaux utilisés, résistances de contact, métallisation et résistances internes des transistors des cellules) . Pour ces raisons, le dispositif de lecture comprend habituellement des moyens de précharge, pour charger la capacité équivalente d'une ligne de bit sélectionnée en lecture à une tension déterminée de précharge de lecture. Ensuite, des moyens de génération de courant établissent un courant dans la ligne de bit. Si la cellule sélectionnée absorbe du courant, on détectera une variation de tension sur la ligne. Dans le cas des cellules mémoire de type EPROM, le dispositif de lecture comprend en outre un limiteur de la tension des lignes de bit à un niveau proche de 1 volt, afin de supprimer les risques de programmation de cellules mémoire durant les accès en lecture.

Par ailleurs, la lecture est souvent basée sur la comparaison entre le courant passant dans la cellule sélectionnée en lecture et celui passant dans une cellule de référence.

Par exemple, dans le cas d'une mémoire EPROM ou OTP, les deux états possibles d'une cellule de la mémoire sont l'état vierge (qui est aussi l'état effacé, par rayons UV), et l'état programmé. Les cellules de référence sont toutes dans le même état connu, en général, l'état vierge. Dans cet état, le transistor à grille flottante de la cellule mémoire a une tension de seuil faible, de l'ordre de 1,4 volts par exemple. Dans l'état programmé, cette tension de seuil devient plus élevée, par exemple égale à 5,5 volts.

Le principe de la lecture par comparaison repose sur le fait que si la cellule sélectionnée en lecture est dans l'état effacé, elle est capable d'absorber autant de courant que la cellule de référence placée dans les mêmes conditions de polarisation. Si on lui fournit seulement une fraction de ce courant, elle va faire s'écrouler la tension de la ligne de bit, ce qui sera détecté.

Ainsi, en pratique, un générateur de courant de lecture injecte un courant de lecture déterminé Iref dans la ligne de bit de référence associée à la cellule de référence, et injecte une fraction de ce courant de référence, par exemple la moitié ou le tiers, dans la ligne de bit de donnée associée à la cellule que l'on veut lire. Un amplificateur différentiel de lecture reçoit sur la première entrée différentielle un signal issu de la ligne de bit de donnée et sur la deuxième entrée différentielle un signal issu de la ligne de bit de référence.

Si la cellule lue est effacée, elle tire plus de courant que la fraction de courant de référence que le générateur de courant lui fournit. La première entrée différentielle est alors tirée à une tension U inférieure à la tension Uref sur la deuxième entrée de l'amplificateur différentiel et la sortie de l'amplificateur bascule dans un sens. Si au contraire la cellule lue est programmée, elle absorbe un courant très faible ou aucun courant. La première entrée différentielle est alors tirée à une tension U supérieure à la tension Uref sur la deuxième entrée de l'amplificateur différentiel, et la sortie de l'amplificateur bascule dans l'autre sens.

Ainsi, un dispositif de lecture habituel comprend, un circuit de précharge pour chacune des lignes de bit avec limitation de la tension de ligne de bit, un générateur de courant de lecture dans les lignes de bit et un amplificateur de lecture qui fournit l'information en sortie.

Le circuit de précharge est en pratique un convertisseur courant-tension, qui assure trois fonctions différentes :
- une première fonction de fourniture de courant pour précharger les lignes de bit,
- une deuxième fonction de limitation du potentiel de ligne de bit à une tension de précharge de lecture déterminée, supprimant les risques de programmation et
- une troisième fonction de fourniture d'un signal à l'amplificateur, avec une tension variant fortement avec le courant sur la ligne de bit associée, dans la phase d'évaluation.

Le dispositif de lecture passe donc par différentes phases de fonctionnement : mise en route des circuits de précharge, activation des générateurs de courant de lecture, sélection et précharge des lignes de bit, sélection de la ligne de mot (décodage de rangée). Les niveaux de tension vus par l'amplificateur de lecture sont alors souvent proches de Vdd et ne sont pas liés à l'état de la cellule sélectionnée, mais au circuit de précharge.

A ce moment la cellule sélectionnée en lecture absorbe ou n'absorbe pas de courant. Si il y a absorption de courant (cellule vierge ou effacée), ce courant est d'abord fourni par la capacité de ligne de bit, puis par le générateur de courant de lecture associé. Cette absorption de courant produit une grande variation de tension sur le signal appliqué en entrée de l'amplificateur, ce qui provoque son basculement.

Cependant, la sortie de l'amplificateur oscille pendant toute la durée des variations sur les lignes de bit, ralentissant l'établissement de la donnée réelle en sortie.

En pratique, les séquencements nécessaires à la mise en route des différents circuits du dispositif de lecture et les oscillations parasites de l'amplificateur ralentissent le temps d'accès en lecture. Il faut compter un cycle et demi d'horloge pour obtenir la donnée en sortie. Dans un exemple, on a ainsi un temps d'accès en lecture de 80 nanosecondes typique, 130 nanosecondes maximum.

Pour éviter le problème des oscillations en sortie de l'amplificateur, on trouve des dispositifs de lecture utilisant un latch a la place de l'amplificateur différentiel de lecture. Mais il faut alors prévoir un séquencement externe supplémentaire, pour fournir le signal d'activation de ce latch en fonction de toutes les contraintes de temps et en fonction de la sensibilité du latch. Ce signal d'activation est souvent issu d'un bloc de contrôle utilisant des circuits témoins dits *"dummy"* dans la littérature anglo-saxonne, dimensionnés pour obtenir une marge suffisante, compte tenu des pires cas de propagation.

Dans l'invention, on cherche à améliorer le temps d'accès en lecture d'une mémoire. Dans un exemple pratique, on cherche à assurer un temps d'accès en lecture maximum de 25 nanosecondes au lieu des 80 nanosecondes typiques de l'état de la technique.

L'invention a ainsi pour objet un dispositif de lecture pour mémoire, utilisant un amplificateur différentiel, à temps d'accès très rapide.

Dans l'état de la technique, la lecture est ralentie du fait des séquencements successifs nécessaires et de l'oscillation de l'amplificateur.

Un objet de l'invention est un dispositif de lecture qui n'a pas ces inconvénients.

Un dispositif de lecture selon l'invention comprend en plus des moyens de précharge des lignes de bit de donnée et de référence à un niveau de tension de précharge proche de 1 volt, des moyens de précharge des entrées de l'amplificateur à un niveau de tension de précharge intermédiaire entre le niveau de tension de précharge de l'ordre de 1 volt et celui de la tension d'alimentation Vdd. En pratique, ce niveau s'établit à une valeur proche de 1,5 volt, correspondant à la valeur d'équilibrage des entrées de l'amplificateur différentiel. De cette manière, dans la phase suivante d'évaluation, la sortie de l'amplificateur bascule très vite dans l'un ou l'autre état logique, selon l'état mémorisé dans la cellule sur la ligne de bit sélectionnée.

Ainsi, selon l'invention, on a une précharge des lignes de bit de donnée et de référence à une tension de précharge de lecture, proche de 1 volt, en combinaison avec une précharge des entrées de l'amplificateur à un niveau de tension intermédiaire.

L'invention concerne donc un dispositif de lecture pour une mémoire en circuit intégré comprenant un amplificateur différentiel dont une entrée est connectée à une sortie d'un convertisseur courant/tension connecté en entrée à une ligne de bit de donnée sélectionnée comprenant une cellule de la mémoire à lire et dont l'autre entrée est connectée à une sortie d'un convertisseur courant/tension connecté en entrée à une ligne de bit de référence sélectionnée, comprenant une cellule de référence, chaque convertisseur permettant de précharger la ligne de bit associée à une première tension de précharge dans une phase de précharge, le dispositif de lecture comprenant en outre un générateur de courant de lecture pour fournir un courant sur chacune desdites lignes de bit de donnée et de référence, permettant l'établissement de la donnée en sortie du dispositif dans une phase suivante d'évaluation, caractérisé en ce qu'il comprend des moyens de précharge des entrées de l'amplificateur différentiel, pour précharger lesdites entrées à une deuxième tension de précharge, de niveau intermédiaire entre la première tension de précharge et la tension d'alimentation logique Vdd, pendant la phase de précharge.

D'autres caractéristiques et avantages de l'invention sont détaillés dans la description suivante, faite à titre indicatif et non limitatif de l'invention et en référence aux dessins annexés dans lesquels :
- la figure 1 représente un schéma bloc d'un dispositif de lecture selon l'invention, permettant la lecture de cellules d'une mémoire;
- la figure 2 est un schéma plus détaillé du dispositif de lecture représenté sur la figure 1; et
- la figure 3 représente un chronogramme des signaux correspondant au séquencement du dispositif de lecture selon l'invention.

On notera que, dans la description, un signal et sa tension sont parfois désignés sous la même référence.

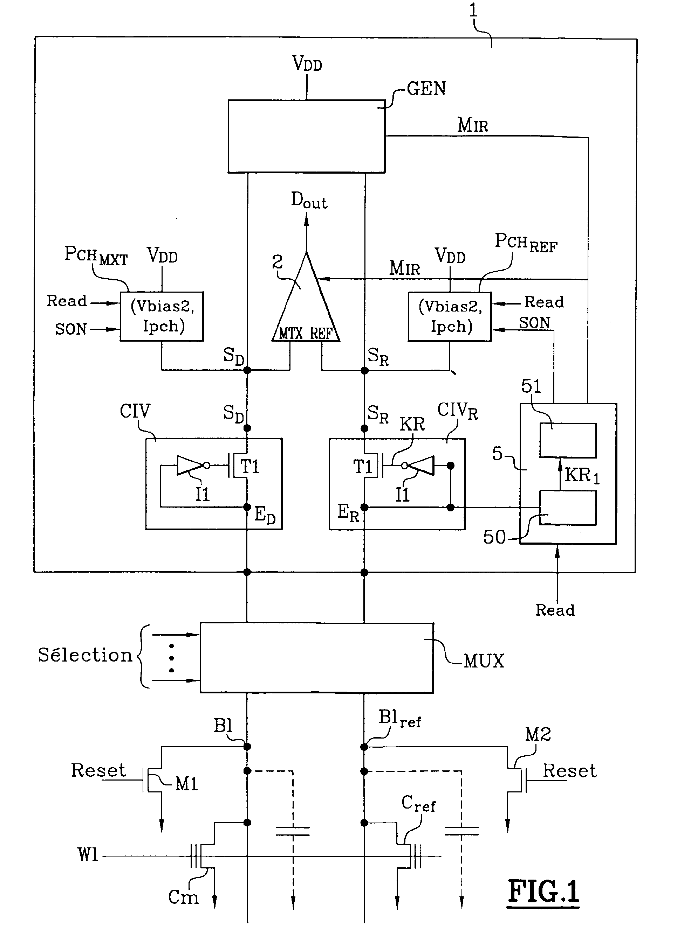

La figure 1 représente schématiquement un dispositif de lecture selon l'invention, pour la lecture de cellules d'une mémoire.

Dans l'exemple, la mémoire est de type Eprom. Une cellule de cette mémoire comprend un transistor à grille flottante dont le drain est connecté à une ligne de bit du plan mémoire et la grille est connectée à une ligne de mot. La ou les cellules de référence sont en général situées sur une ligne de bit de référence, en bout de plan mémoire.

L'architecture de la mémoire peut être plus ou moins complexe, avec ou sans transistors d'accès, avec regroupement de lignes de bit ou autres et la mémoire peut être d'un autre type (non volatile ou autre). L'invention s'applique ainsi à tous les différents types et architectures mémoire.

Sur la figure 1, on a représenté une ligne de bit de donnée Bl et une ligne de bit de référence Bl_{ref} de la mémoire. On a aussi représenté une cellule mémoire référencée Cm, pour la ligne de bit de donnée et une cellule mémoire référencée Cref, pour la ligne de bit de référence. Dans l'exemple, ces cellules sont formées d'un transistor à grille flottante, dont le drain est connecté à la ligne de bit associée. Leur grille est connectée à une ligne de mot Wl.

Enfin, des transistors TM1 et TM2 de mise à la masse des lignes de bit de donnée et de référence sont prévus, pour décharger les lignes de bit avant tout cycle d'accès à la mémoire, en lecture ou en écriture. Ces transistors sont commandés par un signal de réinitialisation Reset.

Lorsque la cellule mémoire Cm est adressée en lecture, la ligne de bit de donnée Bl et la ligne de bit de référence Bl_{ref} sont d'abord sélectionnées pour être connectées à un dispositif de lecture 1, par un circuit multiplexeur MUX. Puis la ou les lignes de mot sont sélectionnées. Ces sélections sont assurées par un circuit de décodage (non représenté) qui fournit notamment des signaux de sélection appliqués au circuit multiplexeur, et qui applique des niveaux de tension appropriés sur les lignes de mot.

Le multiplexeur 2 ne sera pas détaillé. Il comprend de manière connue un ensemble de transistors de commutation pour agir comme des courts-circuits ou au contraire comme des circuits ouverts, selon le niveau logique d'un signal de sélection correspondant.

Il permet de connecter une ligne de bit de donnée sélectionnée Bl sur une entrée de donnée E_{D} d'un dispositif de lecture 1 correspondant et de connecter une ligne de bit de référence correspondante sur une entrée de référence E_{R} du dispositif de lecture.

En pratique, on dispose de plusieurs dispositifs de lecture 1, permettant l'accès en lecture ou en écriture à plusieurs lignes de bit simultanément. On peut ainsi avoir 8,10, 12, 16 ou 32 dispositifs de lecture 1 et autant de multiplexeurs dans le circuit mémoire.

Les cellules mémoire sont sélectionnées en lecture par application d'une tension de lecture sur leur grille, par la ligne de mot correspondante. Dans l'exemple, la cellule à lire et la cellule de référence ont leurs grilles connectées à la même ligne de mot Wl.

La structure générale d'un dispositif de lecture selon l'invention comprend un amplificateur différentiel 2, un générateur de courant de lecture GEN, des circuits de précharge P_{RCH_{MTX}} et P_{RCH_{REF}} et des convertisseurs courant/tension C_{IV_{D}} et C_{IV_{R}}.

L'amplificateur différentiel 2 fournit l'information Dout représentative de l'état programmé ou non de la cellule sélectionnée en lecture et fonction des niveaux de tension appliqués sur ses entrées MTX et REF. L'entrée MTX de l'amplificateur 2 est connectée à la sortie S_{D} d'un convertisseur courant/tension C_{IV_{D}} connecté en entrée E_{D} du dispositif de lecture à la ligne de bit de donnée Bl sélectionnée.

L'autre entrée REF de l'amplificateur 2 est connectée à la sortie S_{R} d'un convertisseur courant/tension C_{IV_{D}} connecté par l'entrée E_{R} à la ligne de bit de référence Bl_{ref}.

Le générateur de courant de lecture GEN a une structure en miroir de courant pour générer un courant de référence I_{R} sur la ligne de bit de référence sélectionnée et un courant I_{D} égal à une fraction de ce courant de référence sur la ligne de bit de donnée sélectionnée. On a ainsi I_{R}=k.I_{D}, où k peut prendre des valeurs comprises entre 1,5 et 4, en fonction des caractéristiques des transistors utilisés dans la structure miroir de courant. Le générateur de courant de lecture comprend une première branche connectée sur la sortie de donnée S_{D} du convertisseur C_{IV_{D}} et une deuxième branche connectée sur la sortie de donnée S_{R} du convertisseur C_{IV_{R}} .

Selon l'invention, le dispositif de lecture 1 comprend en outre un circuit de précharge de chacune des entrées de l'amplificateur à une tension de précharge, de niveau intermédiaire entre la tension de précharge des lignes de bits et la tension d'alimentation logique Vdd.

Le dispositif de lecture selon l'invention comprend ainsi un premier circuit de précharge P_{RECH_{MTX}} de l'entrée de donnée MTX de l'amplificateur et un deuxième circuit de précharge P_{RECH_{REF}} de l'entrée de référence REF de l'amplificateur.

Le premier circuit de précharge est connecté entre la tension d'alimentation logique Vdd et la sortie S_{D}. Il est commandé par un signal logique SON. Quand il est activé, il amène la sortie S_{D}, et donc l'entrée MTX de l'amplificateur, à une tension de précharge Vbias2, par injection d'un courant de précharge Ipch.

Le deuxième circuit de précharge est connecté entre la tension d'alimentation logique Vdd et la sortie S_{R}. Il est commandé par un signal logique SON. Quand il est activé, il amène la sortie S_{R}, et donc l'entrée REF de l'amplificateur, à une tension de précharge Vbias2, par injection d'un courant de précharge Ipch.

Si le générateur de courant de lecture est activé pendant la précharge, il va faire monter les sorties S_{D} et S_{R} au niveau de la tension d'alimentation logique. Les circuits de précharge pourraient compenser cet effet, mais avec une sur-consommation. Pour cette raison, le générateur de lecture est commandé par un signal logique MIR, et les circuits de précharge par un signal logique SON, de manière à inhiber le générateur de courant de lecture pendant la phase de précharge. Ces signaux logiques sont dans l'exemple générés en interne du dispositif de lecture, par un circuit logique de contrôle 5, en sorte qu'en phase de précharge, le générateur de courant de lecture est désactivé et les circuits de précharge sont activés et qu'en phase suivante d'évaluation, le générateur de courant de lecture est activé et les circuits de précharge sont désactivés. Ce circuit logique de contrôle comprend des moyens de détection 50 du niveau de l'entrée E_{R} connectée à la ligne de bit de référence sélectionnée Bl_{ref} et des moyens logiques 51 qui fournissent les signaux logiques MIR et SON en fonction de la sortie KR1 des moyens de détection 50. Le principe de cette détection sera expliqué plus loin.

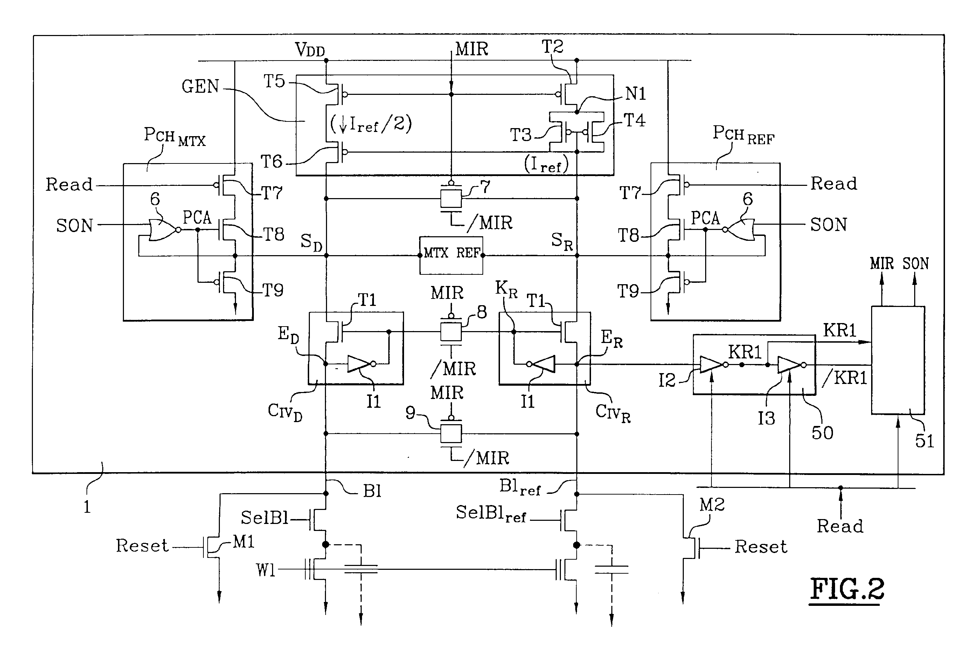

Un exemple de réalisation détaillé des différents circuits du dispositif de lecture 1 est représenté sur la figure 2.

Le générateur de courant de lecture GEN comprend deux branches à transistors MOS de type P.

La première branche comprend un transistor de commutation T2, connecté entre la tension d'alimentation Vdd du circuit intégré et un noeud N1 et deux transistors en parallèle T3 et T4 entre ce noeud N1 et la sortie S_{R}. Ils sont montés en miroir de courant avec leurs grilles et leurs sources reliées en commun. Lorsque le transistor de commutation T2 est activé, transmettant la tension d'alimentation Vdd sur le noeud N1, on obtient le courant de lecture de référence IR. Ce courant est principalement fonction des caractéristiques de la cellule de référence et de la ligne de bit de référence. La tension sur les grilles et sources reliées en commun s'établit à un niveau VREF. La sortie S_{R} du convertisseur, et donc l'entrée REF de l'amplificateur différentiel, s'établissent à ce niveau de tension.

La deuxième branche comprend un transistor de commutation T5 et un transistor T6 connectés en série entre la tension d'alimentation Vdd du circuit intégré et la sortie S_{D}. Ce transistor T6 a sa grille commandée par la connexion grilles-sources des transistors T3 et T4 de la première branche. Si les transistors T3, T4 et T6 sont identiques, on obtient de cette manière un courant de lecture de donnée I_{D} égal à I_{R}/k, lorsque le transistor de commutation T5 est passant et amène la tension Vdd sur le drain du transistor T6. Dans l'exemple, k est inférieur ou égal à 2, suivant le niveau de la tension d'alimentation logique Vdd. La tension sur la sortie S_{D} du convertisseur, et donc sur l'entrée MTX de l'amplificateur, s'établit à un niveau de tension qui est fonction de l'état de la cellule mémoire sélectionnée en lecture sur la ligne de bit de donnée. Si elle est programmée elle absorbe peu de courant, voire pas de courant, et ce niveau s'établit à Vdd. Si elle est effacée, elle appelle un fort courant, plus que ne peut fournir le générateur de courant, et ce niveau de tension se rapproche de 0.

Chacun des convertisseurs courant/tension C_{IV_{D}} et C_{IV_{R}} comprend de manière connue, dans la réalisation la plus simple, une boucle de contre-réaction formée d'un transistor T1 et d'un inverseur I1. Dans l'exemple, le transistor T1 est un transistor MOS de type N. Le drain d du transistor T1 fournit la sortie du convertisseur (S_{D}, S_{R}). La source s du transistor T1, connectée en entrée du convertisseur (E_{D}, E_{R}) est rebouclée sur la grille g du transistor T1 au travers de l'inverseur I1, pour établir un asservissement imposant une tension de précharge Vbias1 proche de 1 volt en entrée du convertisseur E_{D}, E_{R}. Les caractéristiques (dimensions W/L et tension de seuil) du transistor T1 et celles des transistors constituant l'inverseur I1 définissent la valeur de la tension de précharge Vbias1 que le convertisseur tend à imposer sur son entrée. Le niveau de cette tension de précharge Vbias1 est établi de sorte que les cellules de la ligne de bit connectée en entrée du convertisseur ne puissent pas se programmer dans les phases de lecture.

Les lignes de bit sont ainsi préchargées chacune à la tension de précharge Vbias1 par le convertisseur courant/tension correspondant, qui assure la fonction de précharge et de limitation de tension sur ces lignes.

Les circuits de précharge sont identiques. Si on prend le circuit de précharge côté donnée, il comprend deux transistors T7 et T8 connectés en série entre la tension d'alimentation Vdd et la sortie S_{D} du convertisseur courant/tension correspondant. Dans l'exemple, ce sont des transistors MOS, le transistor T7 étant de type P et le transistor T8 de type N. Le transistor, T7 est de préférence commandé par un signal de commande de lecture Read, ce qui permet de n'appliquer la tension d'alimentation Vdd sur le drain du transistor T8, que lorsque l'on a un cycle de lecture (signal Read actif à "0" dans l'exemple). Le transistor T8 a sa source connectée à la sortie de donnée S_{D}. Il est commandé sur sa grille par un signal analogique PCA fourni par un circuit 6 à portes logiques recevant sur une entrée le signal logique SON, l'autre entrée étant connectée à la sortie S_{D}.

La boucle de contre-réaction (T1, I1) définit ainsi le seuil bas de précharge des noeuds S_{D} et S_{R}, soit Vbias1 de l'ordre de 1 volt.

Dans l'exemple ce circuit 6 est formé d'une porte NON OU, le signal logique SON étant tel que sur le niveau logique "0", il active le circuit de précharge et sur le niveau haut "1", il l'empêche de fonctionner.

Ainsi, la commande PCA du transistor T8 est telle que lorsque le signal SON est actif ("0"), le transistor T8 est passant tant que le niveau de tension sur la sortie de donnée S_{D} n'est pas suffisant, c'est à dire, inférieur à la tension de précharge Vbias2.

En pratique, cette tension de précharge est proche du niveau idéal de repos de l'amplificateur, pour optimiser la vitesse de lecture, soit environ à 1,5 volt. Ceci permet d'obtenir ensuite un basculement très rapide de l'amplificateur dans l'un ou l'autre état, en phase d'évaluation. La valeur de cette tension de précharge est définie par les caractéristiques des différents transistors du circuit de précharge, c'est à dire les transistors T7 et T8 et les transistors formant le circuit 6.

De préférence, le circuit de précharge comprend un autre transistor T9, pour tirer la sortie S_{D} vers la masse, si, la tension sur cette sortie monte trop ("overshut"), dû à des couplages ou au séquencement des différents signaux de contrôle.

Dans l'exemple, le transistor T9 est un transistor MOS de type P commandé sur sa grille par le signal PCA.

Le circuit logique de contrôle 5 permet de générer les signaux logiques MIR et SON qui permettent d'activer ou non le générateur de courant de lecture et les circuits de précharge.

On a vu qu'il est nécessaire de n'activer le générateur de courant de lecture GEN qu'après l'arrêt de la précharge des entrées de l'amplificateur selon le principe de l'invention, pour ne pas perdre le bénéfice de cette précharge. Le problème se situe entre la phase de fin de précharge et le moment où les convertisseurs CIV_{D} et CIV_{R} sont activés. Le noeud S_{D} est isolé car la ligne de bit de donnée est préchargée. Si le générateur de lecture était actif, les cellules mémoire à lire et de référence n'étant pas sélectionnées dans cette phase, il pourrait tirer les entrées côté donnée et côté référence de l'amplificateur au niveau de la tension d'alimentation logique Vdd selon les séquencements des différents signaux de contrôle. On ne pourrait donc pas obtenir la précharge des entrées de l'amplificateur à un niveau intermédiaire selon l'invention.

Aussi, dans le cycle de lecture, on a une phase de précharge et une phase d'évaluation.

Dans la phase de précharge, on active les circuits de précharge des entrées de l'amplificateur (P_{RECH_{MTX}},P_{RECH_{REF}}). Ces circuits injectent du courant Ipch pour faire monter la tension sur la sortie des convertisseurs, ce qui permet le fonctionnement de ces derniers on assure ainsi la précharge des lignes de bit (C_{IV_{D}}, C_{IV_{R}}) à la tension de précharge Vbias1.

Quand la phase de précharge est terminée, les sorties S_{D} et S_{R} sont isolées des entrées E_{D} et E_{R}, et donc très sensibles à toutes perturbations. Les sorties sont préchargées à Vbias2, proche de 1,5 volt et les entrées sont préchargées à Vbias1, proche de 1 volt.

Dans la phase suivante d'évaluation, les circuits de précharge sont arrêtés et le générateur de courant de lecture est activé.

De manière avantageuse, pour ne pas être dépendant des variations diverses des paramètres de charge dues aux conditions de fonctionnement et aux caractéristiques du procédé de fabrication, et pour suivre les variations de charge dans les lignes de bit sélectionnées en lecture, on prévoit des moyens de détection interne permettant de faire passer le dispositif de lecture de la phase de précharge à la phase d'évaluation.

Le circuit logique de contrôle 5 du dispositif de lecture a ainsi pour fonction de détecter des conditions d'arrêt sur un signal affecté par la phase de précharge et de générer les signaux logiques MIR et SON.

On peut utiliser plusieurs signaux internes pour effectuer cette détection.

Dans un mode de réalisation préféré de l'invention et comme représenté sur les figures 1 et 2, on détecte les conditions d'arrêt à partir du niveau de tension sur l'entrée E_{D} du convertisseur du dispositif de lecture, associé à la ligne de bit de référence.

On a ainsi une détection très rapide et très fiable du début de la décharge de la ligne de bit de référence par la cellule de référence, indiquant que la phase de précharge de la ligne de bit est terminée.

En effet, on a vu que lorsque les lignes de bit de donnée Bl et de référence Bl_{ref} sélectionnées sont préchargées à la tension Vbias1 par le convertisseur courant/tension associé, les transistors T1 sont bloqués, en sorte que les sorties S_{D} et S_{R} des convertisseurs et les circuits en aval des convertisseurs (circuits de précharge, générateur de courant, amplificateur) se trouvent isolés des entrées E_{D} et E_{R} et donc des lignes de bit. La tension sur les sorties S_{D} et S_{R} continue à monter en tension, du fait des circuits de précharge des entrées de l'amplificateur, pour atteindre le niveau Vbias2.

Lorsque la ligne de mot Wl correspondant à la cellule à lire est sélectionnée (par le circuit de décodage), la cellule de référence conduit du courant, déchargeant la capacité parasite de la ligne de bit associée (capacité représentée en pointillé sur les figures 1 et 2).

Lorsque la capacité parasite de la ligne de bit de référence est déchargée, le niveau de tension sur l'entrée correspondante du dispositif de lecture commence à baisser, ce qui est détecté par la boucle d'asservissement (I1) du convertisseur courant/tension associé CIV_{R}, entraînant la remise en conduction du transistor Tl de la boucle.

Côté ligne de bit de donnée et entrée de donnée E_{D}, on n'est pas certain de consommer du courant : cela dépend de l'état de la cellule sélectionnée en lecture.

Ainsi la détection des conditions d'arrêt est effectuée côté ligne de bit de référence, où l'on est certain de consommer du courant.

Les conditions d'arrêt selon l'invention correspondent alors à la combinaison de deux événements : le passage en boucle ouverte des convertisseurs et la mise en conduction des cellules mémoire, ce qui entraîne une baisse de tension sur l'entrée E_{R}.

Ainsi, et comme représenté sur la figure 1, le circuit logique de contrôle 5 reçoit en entrée le signal disponible au noeud d'entrée de référence E_{R} du dispositif de lecture. Il reçoit en outre le signal de commande de lecture Read.

Il comprend des moyens de détection 50 et des moyens logiques 51 de génération du signal de commande MIR qui est appliqué en entrée du générateur de commande et du signal de commande SON, qui commande les circuits de précharge des entrées de l'amplificateur.

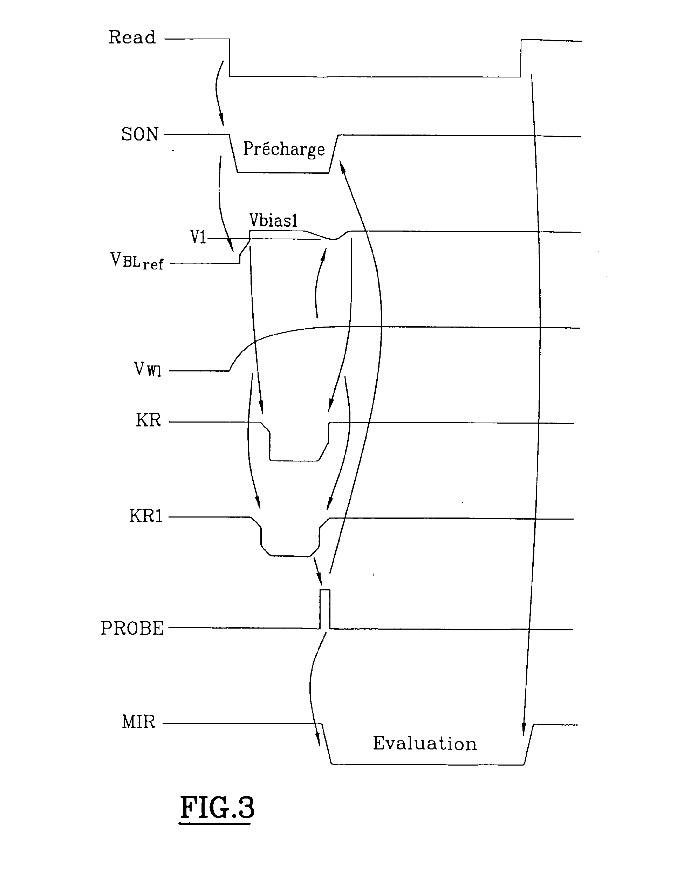

Le chronogramme représenté sur la figure 3 montre le séquencement des différents signaux du dispositif de lecture lors d'un cycle de lecture. Plus précisément, on a représenté sur cette figure le signal de commande de lecture Read, le signal de commande SON, la tension VBl_{ref} sur la ligne de bit de référence, la tension VW1 sur la ligne de mot, le signal KR de sortie de l'inverseur I1 du convertisseur côté référence, le signal de sortie KR1 des moyens de détection 50, et le signal de commande MIR.

Quand on a un accès en lecture à la mémoire, un circuit de contrôle d'accès (non représenté) génère une impulsion (active sur le niveau "0") sur le signal de commande de lecture Read, les lignes de bit de données Bl et de référence Bl_{ref} étant sélectionnées, et donc connectées en entrée au dispositif de lecture.

Sur réception de l'impulsion du signal Read, le circuit logique de contrôle de lecture 5 fait passer le signal de contrôle SON de son niveau passif, "1" dans l'exemple, a son niveau actif, "0" dans l'exemple, ce qui permet de mettre en route les circuits de précharge des entrées. Ces circuits de précharge des entrées injectent du courant Ipch, permettant la précharge des lignes de bit de données et de référence à la tension Vbias1. La tension VBl_{ref} sur la ligne de bit de référence monte progressivement depuis 0 jusqu'à Vbias1, en passant par un seuil de détection V1 des moyens de détection 50. Le signal KR1 de sortie de détection bascule dans un sens, de "1" à "0" dans l'exemple. Puis c'est l'inverseur I1 du convertisseur qui bascule, de "1" à "0", signifiant que la précharge des lignes de bit est effectuée et isolant l'entrée de référence de la sortie de référence. Notamment, le transistor T1 ne passe plus de courant.

La ligne de mot Wl est sélectionnée : la tension VW1 sur cette ligne de mot monte progressivement depuis 0 jusqu'à un niveau de tension de polarisation de lecture, typiquement Vdd. La cellule de référence se met à conduire dès que le niveau de tension VW1 est suffisant. Elle tend à décharger la ligne de bit de référence, ce qui se traduit par une baisse de tension sur cette ligne, puisqu'à ce moment il n' y a pas d'autre source de courant que la capacité parasite de la ligne. Cette baisse de tension est détectée par les moyens de détection 50 : Le signal KR1 de sortie de détection bascule dans l'autre sens, de "0" à "1".

Le front actif de cette détection active les moyens logiques de génération 51. Ces moyens font remonter le signal SON à "1" et descendre le signal MIR à 0, pour d'une part couper les circuits de précharge et d'autre part activer le générateur de courant de lecture.

On comprend bien sur le chronogramme que les moyens de détection 50 doivent détecter la chute de tension sur la ligne de bit avant l'inverseur I1 du convertisseur, sinon ce dernier se remettrait en action faisant remonter le niveau sur la ligne de bit : on risquerait de ne jamais détecter les conditions d'arrêt.

Un exemple de réalisation des moyens de détection est détaillé sur la figure 2. Dans cet exemple, ils comprennent deux inverseurs en série I2 et I3, permettant de fournir le signal de détection KR1 et son complémentaire /KR1 aux moyens logiques 51 du circuit logique de contrôle 5. L'inverseur I2 est dimensionné pour basculer avant l'inverseur I1 du convertisseur.

Les signaux de commande SON et MIR sont ramenés à leur niveau inactif, par la fin du cycle de lecture (Read à 1 dans l'exemple).

Les moyens logiques 51 ne seront pas détaillés. Ils ne présentent aucune difficulté de réalisation pour l'homme du métier. Typiquement, ils comprendront un générateur d'une impulsion, telle que l'impulsion PROBE représentée sur la figure 3, déclenché par le front actif de la détection c'est à dire dans l'exemple, par le front montant "0" vers "1" du signal KR1. Les moyens logiques 51 comprendront par ailleurs des portes logiques pour générer les signaux SON et MIR correspondant au chronogramme de la figure 3, en fonction du signal de commande de lecture Read et de cette impulsion.

Dans un perfectionnement de l'invention représenté sur la figure 2, des moyens d'égalisation sont prévus, pour équilibrer parfaitement les deux côtés donnée et référence de l'amplificateur du dispositif de lecture, améliorant la vitesse de basculement de cet amplificateur en phase d'évaluation. Ceci est obtenu en prévoyant des circuits portes de transfert ("passgate" en littérature anglo-saxonne). Un ou plusieurs de ces circuits peuvent être utilisés. Dans l'exemple un premier circuit porte 7 est ainsi prévu entre les deux noeuds de sortie S_{D} et S_{R}; un deuxième circuit porte 8 est prévu entre les sorties des inverseurs I1 des boucles d'asservissement ; et un troisième circuit porte 9 est prévu entre les entrées E_{D} et E_{R} des convertisseurs. Quand ils sont activés, ces circuits portes court-circuitent les noeuds correspondants, qui sont donc amenés au même niveau de tension. Ces circuits doivent donc être invalidés dès que l'on passe en phase d'évaluation. Ils sont donc commandés par le signal de commande MIR et son complémentaire /MIR.

Un procédé de lecture selon l'invention avec précharge des entrées de l'amplificateur à un niveau intermédiaire de tension, entre le niveau de précharge des lignes de bit et le niveau de tension d'alimentation logique Vdd et égalisation des différents noeuds internes du dispositif de lecture permet donc un auto-séquencement de la phase de lecture. En outre l'amplificateur, dès qu'il est activé par le signal de commande MIR, va aller très vite à l'état de sortie correspondant à la cellule à lire. On gagne ainsi beaucoup de temps dans la lecture. En pratique, on a pu atteindre des temps d'accès en lecture inférieurs à 15 nanosecondes, avec un dispositif de lecture selon l'invention réalisé en technologie HCMOS, 0,35 microns.

## Revendications

1. Dispositif de lecture pour une mémoire en circuit intégré comprenant un amplificateur différentiel (2) dont une entrée (MTX) est connectée à une sortie (Sd) d'un convertisseur courant/tension (C_{IVD}) connecté en entrée (E_{D}) à une ligne de bit de donnée sélectionnée (Bl) comprenant une cellule de la mémoire à lire (Cm) et dont l'autre entrée (REF) est connectée à une sortie (S_{R}) d'un convertisseur courant/tension (C_{IVR}) connecté en entrée (E_{R}) à une ligne de bit de référence sélectionnée (Bl_{ref}), comprenant une cellule de référence, chaque convertisseur permettant de précharger la ligne de bit associée à une première tension de précharge (Vbias1) dans une phase de précharge, le dispositif de lecture comprenant en outre un générateur de courant de lecture pour fournir un courant sur chacune desdites lignes de bit de donnée et de référence, permettant l'établissement de la donnée en sortie du dispositif dans une phase suivante d'évaluation, caractérisé en ce qu'il comprend des moyens de précharge (P_{RECH_{MTX}}, P_{RECH_{REF}}) des entrées de l'amplificateur différentiel, pour précharger lesdites entrées à une deuxième tension de précharge (Vbias2), de niveau intermédiaire entre la première tension de précharge (Vbias1) et la tension d'alimentation logique Vdd, pendant la phase de précharge.

2. Dispositif de lecture selon la revendication 1, caractérisé en ce que le générateur de courant de lecture (GEN) reçoit un signal de commande MIR, ledit signal permettant de désactiver ledit générateur pendant la phase de précharge et de l'activer pendant la phase suivante d'évaluation.

3. Dispositif de lecture selon la revendication 1 ou 2, caractérisé en ce que la deuxième tension de précharge (Vbias2) est de l'ordre de 1,5 volt.

4. Dispositif de lecture selon l'une quelconque des revendications précédentes, caractérisé en ce qu'il comprend des moyens d'égalisation (7, 8, 9) de noeuds internes correspondants du dispositif de lecture, commandés par des signaux de commande pour activer ces moyens d'égalisation en phase de précharge et les désactiver en phase d'évaluation.

5. Dispositif de lecture selon la revendication 4, caractérisé en ce que ces moyens d'égalisation comprennent une porte de transfert (7) connectée entre les deux entrées (MTX, REF) de l'amplificateur (2).

6. Dispositif de lecture selon la revendication 4, caractérisé en ce que ces moyens d'égalisation comprennent une porte de transfert (8) connectée entre les entrées (E_{D}, E_{R}) des convertisseurs.

7. Dispositif de lecture selon la revendication 4, le convertisseur (C_{IVD}) connecté en entrée à la ligne de bit de donnée et le convertisseur (C_{IVR}) connecté en entrée à la ligne de bit de référence, comprenant chacun un transistor (T1) connecté entre l'entrée et la sortie du convertisseur, et un inverseur (I1) connecté entre l'entrée du convertisseur et la grille dudit transistor (T1), caractérisé en ce que les moyens d'égalisation comprennent une porte de transfert (9) connectée entre les grilles des transistors T1 de ces convertisseurs.

8. Dispositif de lecture selon l'une quelconque des revendications 1 à 7, caractérisé en ce qu'il comprend des moyens internes de détection du passage de la phase de précharge à la phase suivante d'évaluation.

9. Dispositif de lecture selon la revendication 8, le convertisseur (C_{IVD}) connecté en entrée à la ligne de bit de donnée et le convertisseur (C_{IVR}) connecté en entrée à la ligne de bit de référence, comprenant chacun un transistor (T1) connecté entre l'entrée et la sortie du convertisseur, et un inverseur (I1) connecté entre l'entrée du convertisseur et la grille dudit transistor (T1), caractérisé en ce que les moyens internes de détection comprennent des moyens de détection (50) d'une chute de tension sur l'entrée (E_{R}) du convertisseur associé à la ligne de bit de référence sélectionnée préchargée à la première tension de précharge (Vbias1), pour faire passer le dispositif de lecture de la phase de précharge à la phase suivante d'évaluation.

10. Dispositif de lecture selon la revendication 9, caractérisé en ce que lesdits moyens de détection (50) comprennent un inverseur (I2) dimensionné pour détecter la chute de tension avant l'inverseur (I1) du convertisseur associé à la ligne de bit de référence.

11. Mémoire en circuit intégré comprenant un dispositif de lecture selon l'une quelconque des revendications précédentes.
